Europäisches Patentamt

European Patent Office

Office européen des brevets

(19)

(11) Numéro de publication: **0 143 677**
**A 1**

## (12) DEMANDE DE BREVET EUROPEEN

(21) Numéro de dépôt: 84401838.2

(22) Date de dépôt: 17.09.84

(51) Int. Cl.⁴: **G 01 B 3/30**, G 01 B 3/34, G 01 B 3/14

(30) Priorité: 18.11.83 FR 8318375

(43) Date de publication de la demande: 05.06.85
Bulletin 85/23

(84) Etats contractants désignés: AT BE CH DE GB IT LI LU NL SE

(71) Demandeur: UNION CARBIDE FRANCE, 4, Place des Etats-Unis, F-94518 Rungis (FR)

(72) Inventeur: Costa, Laurent, 4, Allée des Cèdres, F-92410 Ville d'Avray (FR)
Inventeur: Honnore, Didier, 133, rue du Cherche-Midi, F-75015 Paris (FR)
Inventeur: Bleijs, C. A., 25, rue Duvivier, F-75007 Paris (FR)

(74) Mandataire: Santarelli, Marc, Cabinet Rinuy et Santarelli 14, avenue de la Grande Armée, F-75017 Paris (FR)

(54) **Appareil destiné à identifier et indiquer la référence d'une pile électrique dans une marque donnée de piles.**

(57) L'invention se rapporte à un appareil destiné à identifier et indiquer la référence d'une pile électrique dans une marque donnée de piles, en fonction du diamètre, de l'épaisseur et de la résistance interne d'une pile quelconque du commerce.

L'appareil recueille électriquement l'information d'un récepteur de contour (2-3), cette information étant transmise à un microprocesseur (14) convenablement programmé, lequel indique sur un écran électronique (4), de préférence à cristaux liquides, la ou les références de pile dans la marque considérée, correspondant à toute pile présentée dans l'appareil.

L'invention s'applique, d'une façon générale, aux instruments d'identification.

## Appareil destiné à identifier et indiquer la référence d'une pile électrique dans une marque donnée de piles

La présente invention a pour objet un appareil destiné à identifier et indiquer la référence d'une pile électrique dans une marque donnée de piles, en fonction du diamètre, de l'épaisseur et de la résistance interne d'une pile quelconque du commerce.

Cet appareil est destiné, plus particulièrement mais non exclusivement, à identifier, dans une marque considérée, la ou les références d'une pile convenant à une montre, qu'elle soit à aiguilles ou à affichage électronique.

L'appareil selon l'invention s'applique dans ce cas au domaine de l'horlogerie, à l'usage des horlogers eux-mêmes comme des clients, mais il peut être applicable également à d'autres domaines de dispositifs électroniques faisant appel à des piles.

L'appareil selon l'invention se caractérise en ce qu'il recueille électriquement l'information d'un récepteur de contour, cette information étant transmise à un microprocesseur convenablement programmé lequel indique au moyen d'un senseur approprié (écran électronique, de préférence à cristaux liquides), la ou les références de pile dans la marque considérée, correspondant à toute pile présentée dans l'appareil.

Suivant une forme de réalisation, le récepteur de contour est un moyen photoélectrique.

Suivant une autre forme de réalisation, le récepteur de contour est une caméra vidéo.

Suivant encore une autre forme de réalisation, le récepteur de contour comprend au moins un calibre ou gabarit associé à un moyen spécifiquement électrique de recueil et de transmission de l'information.

Le moyen électrique dans ce cas peut être un curseur à la disposition de l'utilisateur, le curseur étant placé en regard de la pile disposée dans le calibre, à l'endroit où elle correspond à une des cotes du calibre.

Suivant une variante, le moyen électrique est constitué par de simples contacts disposés sur le calibre, à chaque cote du calibre correspondant au moins un contact électrique.

Suivant encore une autre forme de réalisation, le

0143677

récepteur de contour comprend au moins un palpeur mobile associé à un moyen de recueil et de transmission de l'information.

Le moyen de recueil et de transmission de l'information peut être un moyen spécifiquement électrique ou un moyen photoélectrique.

Quelle que soit la forme de réalisation du récepteur, l'appareil comporte également des commutateurs dont l'un permet de considérer la pile en fonction de sa destination sur une montre à aiguilles ou sur une montre à affichage.

Un autre commutateur permet de tester la tension aux bornes de la pile.

D'autres caractéristiques et avantages de la présente invention ressortiront de la description qui va suivre faite en regard des dessins annexés sur lesquels :

- la figure 1 représente en perspective cavalière un appareil selon l'invention dont le récepteur comprend deux calibres associés à des moyens électriques ;

- la figure 2 est un schéma d'une autre forme de réalisation dans laquelle le récepteur est un moyen photoélectrique;

- la figure 3 est un schéma d'une forme de réalisation dans laquelle le récepteur est une caméra vidéo;

- la figure 4 est un schéma d'une forme de réalisation dans laquelle le récepteur de contour comprend au moins un palpeur associé à un moyen électrique de recueil et de transmission de l'information ; et

- la figure 5 est un schéma d'une forme de réalisation dans laquelle le récepteur de contour comprend au moins un palpeur associé à un moyen photoélectrique de recueil et de transmission de l'information.

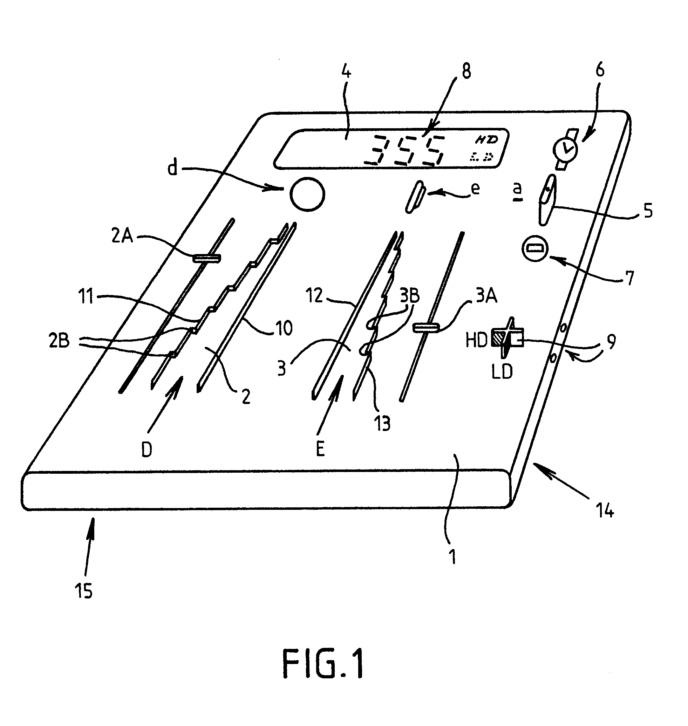

Dans la forme de réalisation représentée à la figure 1, un appareil selon l'invention comprend sur une platine (1) : - deux calibres (2) et (3) ; - deux curseurs correspondants (2A) et (3A) ; - un écran d'affichage électronique à cristaux liquides (LCD) (4) ; - un commutateur (5) à trois positions : - position arrêt ( a) - position montre analogique à aiguilles (6) - position montre digitale à affichage (LCD) (7) pour lesquelles conviennent des piles de résistance interne HD ou LD (forte résistance interne ou faible résistance interne), l'un ou l'autre de ces sigles usuels HD ou LD venant apparaître sur l'écran à cristaux liquides en même temps que la référence (8) dans la marque de pile considérée; — et éventuellement un commutateur-testeur (9) à canaux HD et LD.

La pile à plat est introduite dans l'embouchure (D) du calibre (2) présentant une règle rectiligne (10) et une règle à gradins (11), chaque gradin correspondant à un diamètre donné de pile, l'utilisateur venant mettre le curseur (2A) en vis-à-vis du gradin qui reçoit la pile, en conformité dimensionnelle. Pour la compréhension de l'utilisateur, un diamètre (d) est avantageusement dessiné sur la platine de l'appareil, dans une zone voisine du calibre (2).

La pile est, dans un second stade d'identification, introduite de chant dans l'embouchure (E) du calibre (3) qui présente une règle rectiligne (12) et une règle à gradins (13), chaque gradin correspondant à une épaisseur donnée de pile, l'utilisateur venant mettre le curseur (3A) en vis-à-vis du gradin qui reçoit la pile, en conformité dimensionnelle. Pour la compréhension de l'utilisateur, une pile vue en épaisseur (e) est avantageusement dessinée sur la platine de l'appareil, dans une zone voisine du calibre (3).

Suivant une variante, les curseurs peuvent être remplacés par un ou des contacts électriques fixes (2B-3B) disposés à l'endroit de chaque gradin.

De toute manière, qu'il s'agisse de curseurs mobiles ou de contacts fixes, une information électrique est envoyée à un microprocesseur dont l'accès est figuré par exemple en (14) sur la figure 1.

Un autre accès est figuré par exemple en (15) pour la source électrique de l'appareil selon l'invention.

Il est bien entendu que les calibres (2) et (3) peuvent revêtir une autre configuration, par exemple en pyramide, constituée de deux réglettes à gradins disposées symétriquement par rapport à un axe longitudinal du calibre considéré.

L'appareil selon l'invention a donc un fonctionnement "en sélecteur" mais il peut avoir comme expliqué plus loin un fonctionnement "en testeur" à l'aide du commutateur-testeur (9).

Le fonctionnement "en sélecteur" se fait donc de la façon suivante :

- repérage du diamètre dans le calibre ou gabarit (2) ;

- positionnement du curseur (2A) en face de la position de blocage dans le calibre ;

- repérage de l'épaisseur dans le calibre ou gabarit (3) ;

- positionnement du curseur (3A) en face de la position de blocage dans le calibre ;

- allumage du système par déplacement du commutateur (5) vers la position :

- montre digitale si la pile doit équiper une montre à affichage à cristaux liquides (LCD) (position 7) ;

- montre analogique si la pile doit équiper une montre à aiguilles (position 6).

Lorsque ces trois opérations ont été effectuées, le microprocesseur traite les informations et commande l'affichage de :

- la référence dans la marque considérée ;

- la référence HD ou LD.

Le fonctionnement "en testeur" se fait de la façon suivante :

La pile sélectionnée peut être testée sur l'un des deux canaux HD ou LD du commutateur-testeur (9).

La lecture se fait sur le même écran à affichage à cristaux liquides (LCD) (4) mais affiche directement la tension aux bornes de la pile.

Suivant un exemple, la pile est considérée bonne si la tension est supérieure à 1,4 volt en charge.

La charge est fonction de la résistance interne de la pile.

Sur le canal HD, l'intensité est de 10 mA.

Sur le canal LD, l'intensité est de 1 mA.

Il doit être remarqué que chaque calibre, au lieu d'identifier une seule dimension, peut être conçu pour identifier d'autres dimensions en étant lui-même multidimensionnel, (par exemple tridimensionnel).

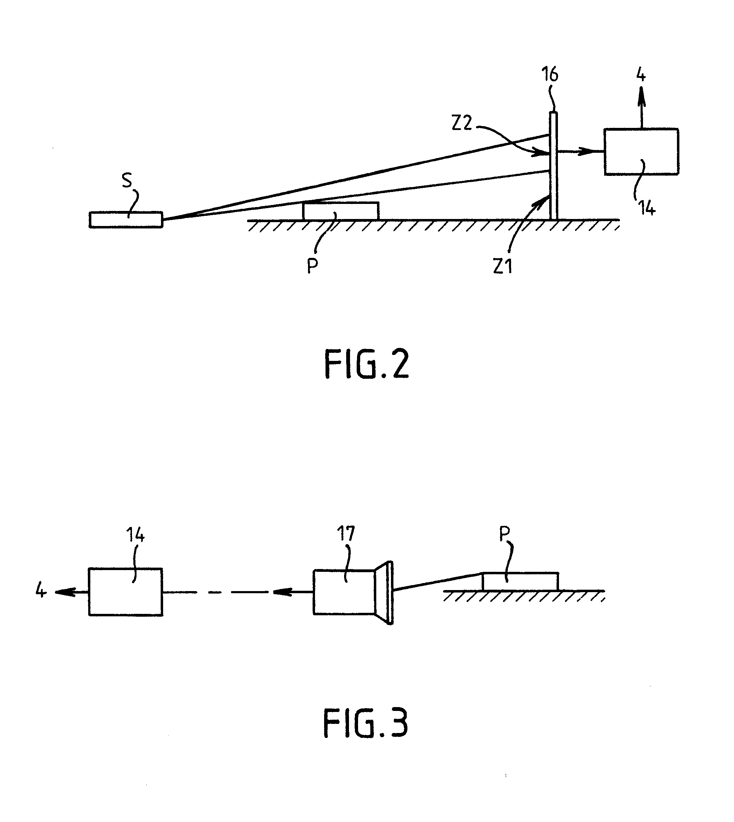

Dans la forme de réalisation schématisée à la figure 2, l'appareil selon l'invention comprend un récepteur photoélectrique (16) et la pile à identifier (P) est placée entre ce récepteur et une source émettrice de radiations lumineuses (S). Ce récepteur est en forme d'écran et reçoit partiellement le faisceau de radiations lumineuses qui est en partie intercepté par la présence de la pile qui est opaque.

Il résulte de cette disposition que l'écran montre une zone d'ombre (Z1)) qui est l'ombre portée de la pile et l'écran photoélectrique délivre alors un courant proportionnel à la surface de la zone éclairée restante (Z2) qui, par voie de conséquence, est fonction de la surface de la zone (Z1) de l'ombre portée sur le récepteur, laquelle est proportionnelle aux dimensions de la pile (diamètre et épaisseur) chaque type de piles ayant une base circulaire et une épaisseur constantes.

La mesure du courant est transmise au microprocesseur (14) convenablement programmé qui indique directement sur l'écran à cristaux liquides (4) la référence de la pile.

Afin d'éviter une dégradation du contour de l'ombre et obtenir une ombre tranchée, la source émettrice (S) est choisie la plus réduite possible.

Dans la forme de réalisation schématisée à la figure 3, l'appareil selon l'invention comprend une caméra vidéo (17) devant laquelle est placée la pile à identifier (P).

Le signal vidéo ainsi obtenu, qui constitue une image, est analysé.

Le microprocesseur (14) permet l'acquisition et le traitement de l'image et l'indication sur l'écran à cristaux liquides (4) de la référence de la pile.

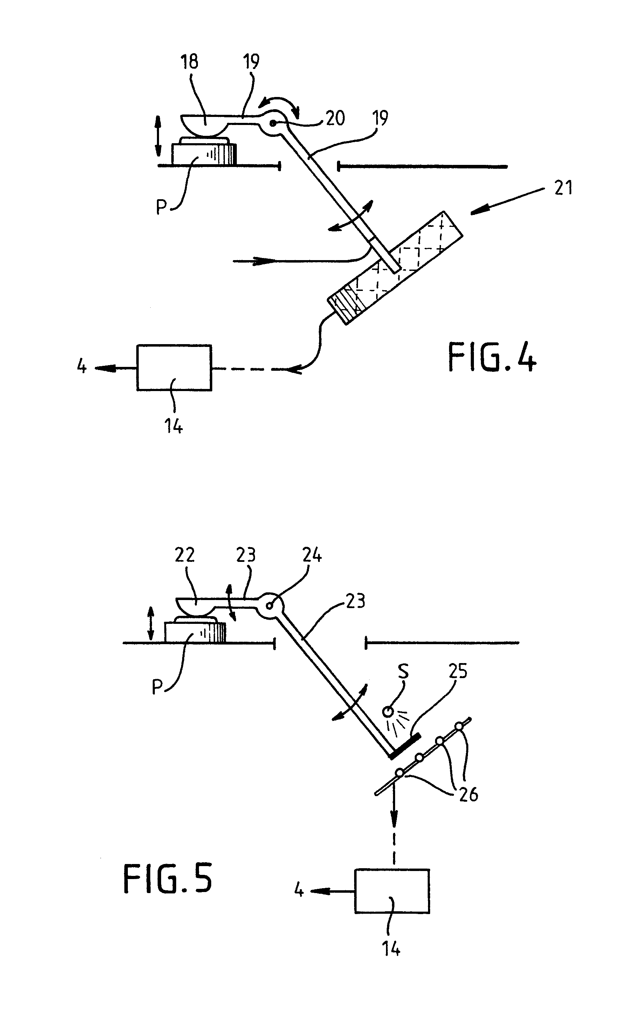

Dans la forme de réalisation schématisée à la figure 4, l'appareil selon l'invention comprend un palpeur mobile, plus précisément un palpeur (18) monté sur l'un des bras d'un levier coudé (19) oscillant autour d'un axe (20). L'autre bras du levier coudé constitue la partie mobile d'un rhéostat (21) dont le signal d'intensité variable est transmis au microprocesseur (14) convenablement programmé qui indique la référence de la pile (P) par le truchement d'un écran à cristaux liquides (4).

Dans le schéma représenté le palpeur (18) identifie le paramètre "épaisseur" de la pile mais l'appareil peut comprendre un deuxième palpeur (non représenté) pour identifier le paramètre "diamètre" de la pile quand la connaissance des deux paramètres est indispensable à l'identification de la pile. Ce deuxième palpeur est identique au premier mais oscille dans un plan perpendiculaire au plan dans lequel travaille le premier palpeur.

Dans la forme de réalisation schématisée à la figure 5, l'appareil selon l'invention comprend également un palpeur (22) monté sur l'un des bras d'un levier coudé (23) oscillant autour d'un axe (2A). L'autre bras du levier coudé porte un occulteur (25) venant masquer par rapport à une source lumineuse (S) un nombre plus ou moins grand de diodes réceptrices (26) en fonction de la position du bras et donc en fonction du paramètre "épaisseur" ou "diamètre".

Le signal résultant est transmis au microprocesseur (14) qui affiche la référence de la pile au moyen d'un écran à cristaux liquides (4).

Bien entendu, comme précédemment, l'appareil peut comprendre deux palpeurs montés perpendiculairement l'un par rapport à l'autre pour permettre l'identification simultanée des deux paramètres "épaisseur" et "diamètre".

Les formes de réalisation à palpeurs mobiles permettent une amplification des différences de taille et une bonne protection du système de mesure.

Il est bien entendu, enfin, que la présente invention n'a été décrite et représentée qu'à titre d'exemple préférentiel et que l'on pourra apporter des équivalences dans ses éléments constitutifs sans, pour autant, sortir du cadre de l'invention .

C'est ainsi que l'écran électronique à cristaux liquides (4) pourrait être remplacé par un autre senseur approprié, par exemple un transducteur microphonique indiquant la référence de la
pile en phonèmes.

8

## REVENDICATIONS

1. Appareil destiné à identifier et indiquer la référence d'une pile électrique dans une marque donnée de piles, caractérisé en ce qu'il recueille électriquement l'information d'un récepteur de contour (2-3-16-17-18-22), cette information étant transmise à un microprocesseur (14) convenablement programmé lequel indique au moyen d'un senseur approprié (écran électronique (4), de préférence à cristaux liquides), la ou les références de pile dans la marque considérée, correspondant à toute pile présentée dans l'appareil.

2. Appareil selon la revendication 1, caractérisé en ce que le récepteur de contour est un récepteur photoélectrique (16) et la pile à identifier est placée entre ce récepteur et une source émettrice de radiations lumineuses (S).

3. Appareil selon la revendication 2, caractérisé en ce que le récepteur photoélectrique est en forme d'écran sur lequel se forme l'ombre portée (Z1) de la pile qui est proportionnelle aux dimensions de la pile (diamètre et épaisseur), l'écran photoélectrique délivrant un courant proportionnel à la surface de la zone éclairée restante (Z2) qui est, par voie de conséquence, fonction de l'ombre portée (Z1).

4. Appareil selon la revendication 1, caractérisé en ce que le récepteur de contour est une caméra vidéo (17) devant laquelleest placée la pile à identifier (P) le microprocesseur (14) permettant l'acquisition et le traitement de l'image et l'indication sur l'écran à cristaux liquides (4) de la référence de la pile.

5. Appareil selon la revendication 1, caractérisé en ce que le récepteur de contour comprend au moins un calibre ou gabarit (2-3), associé à un moyen spécifiquement électrique (2A-3A) ; (2B-3B) de recueil et de transmission de l'information.

6. Appareil selon la revendication 5, caractérisé en ce que le moyen électrique est un curseur (2A-3A) à la disposition de l'utilisateur, le curseur étant placé en regard de la pile disposée dans le calibre, à l'endroit où elle correspond à une des cotes du calibre.

7. Appareil selon la revendication 5, caractérisé en ce que le moyen spécifiquement électrique est constitué par de simples contacts (2B) (3B) disposés sur le calibre, à chaque cote du calibre correspondant au moins un contact électrique.

8. Appareil selon l'une quelconque des revendications 5 à 7, caractérisé en ce qu'il offre deux calibres (2-3) à moyens électriques de transmission de l'information, l'un de ces calibres (2) identifiant le diamètre de la pile alors que l'autre calibre (3) identifie l'épaisseur de la pile.

9. Appareil selon la revendication 1 caractérisé en ce que le récepteur de contour comprend au moins un palpeur mobile (18) associé à un moyen spécifiquement électrique (21) de recueil et de transmission de l'information.

10. Appareil selon la revendication 1 caractérisé en ce que le récepteur de contour comprend au moins un palpeur mobile (21) associé à un moyen photoélectrique (25) de recueil et de transmission de l'information.

11. Appareil selon l'une quelconque des revendications 9 et 10 caractérisé en ce qu'il offre deux palpeurs mobiles, l'un de ces palpeurs identifiant l'épaisseur de la pile, alors que l'autre identifie le diamètre de la pile.

12. Appareil selon l'une quelconque des revendications 1 à 11, caractérisé en ce qu'il comporte un commutateur (5) permettant de considérer la pile en fonction de sa destination sur une montre à aiguilles ou sur une montre à affichage électronique.

13. Appareil selon l'une quelconque des revendications 1 à 12, caractérisé en ce qu'il comporte un commutateur-testeur (9) permettant de tester la tension aux bornes de la pile.

FIG.1

FIG.2

FIG.3

0143677

FIG.4

FIG.5

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | GB-A- 650 588 (CONEX TERNA LTD.) <br> * Page 1, ligne 77 - page 2, ligne 74; figures; revendication 1 * <br><br> --- | 1,5,6 | G 01 B 3/30 <br> G 01 B 3/34 <br> G 01 B 3/14 |
| A | US-A-2 981 005 (N.W. MOE) <br> * En entier * <br><br> --- | 1,5,8 | |
| A | US-A-3 941 484 (BAI CORP.) <br> * En entier * <br><br> --- | 1-4 | |
| A | DE-A-2 162 128 (L. HORN) <br><br> * En entier * <br><br> --- | 1,5,7, 8 | |
| A | GB-A-1 597 940 (GNT AUTO) <br> * Page 1, ligne 63 - page 3, ligne 69; figures; revendications 1,2 * <br><br> --- | 1,5,7 | **DOMAINES TECHNIQUES RECHERCHES (Int. Cl.4)** |
| A | US-A-4 160 599 (J.L. SPERRAZZA) <br> * En entier * <br><br> --- | 1-3 | B 07 C 5/00 <br> G 01 R 31/00 <br> G 07 F 3/00 <br> G 01 B 3/00 <br> G 01 B 5/00 <br> G 01 B 11/00 |
| A | US-A-4 356 481 (NIPPON ELECTRIC CO.) <br> * Figures 1,3,4; colonne 1, lignes 5-68; colonne 3, ligne 11 - colonne 4, ligne 63 * <br><br> ---     -/- | 1,13 | G 05 D 5/00 <br> G 07 D 5/00 <br> G 07 D 7/00 <br> G 07 D 3/00 |

Le présent rapport de recherche a été établi pour toutes les revendications

| Lieu de la recherche | Date d'achèvement de la recherche | Examinateur |
|---|---|---|
| LA HAYE | 15-02-1985 | BROCK T.J. |

Office européen
des brevets

**RAPPORT DE RECHERCHE EUROPEENNE**

0143677
Numéro de la demande

EP 84 40 1838

| | **DOCUMENTS CONSIDERES COMME PERTINENTS** | | | Page 2 |
|---|---|---|---|---|
| Catégorie | Citation du document avec indication, en cas de besoin, des parties pertinentes | Revendication concernée | CLASSEMENT DE LA DEMANDE (Int. Cl.4) | |
| A | GB-A- 724 678 (COMMONWEALTH ENG. CO.) <br> * Figures 2,3; page 2, lignes 54-99; revendications 7,8 * <br><br> ----- | 1,9-11 | | |
| | | | DOMAINES TECHNIQUES RECHERCHES (Int. Cl.4) | |
| | Le présent rapport de recherche a été établi pour toutes les revendications | | | |

| Lieu de la recherche <br> LA HAYE | Date d'achèvement de la recherche <br> 15-02-1985 | Examinateur <br> BROCK T.J. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03.82